# DEMANDE DE BREVET EUROPEEN

(11) **EP 4 636 819 A1**
(43) Date de publication de la demande: **22.10.2025**
(21) Numéro de dépôt: 25169664.7
(22) Date de dépôt: 10.04.2025
(51) Int. Cl.: H01L 21/78, H01L 21/308, H01L 21/683, H01L 23/48

(54) **PROCÉDÉ DE PRÉPARATION D'UN SUBSTRAT STRUCTURÉ POUR COLLAGE DIRECT**

(30) Priorité: 17.04.2024 FR 2403966
(71) Demandeur: Commissariat à l'Energie Atomique et aux Energies Alternatives, 75015 Paris (FR)
(72) Inventeur: MONTMEAT, Pierre, 38054 GRENOBLE CEDEX 09 (FR); FOURNEL, Franck, 38054 GRENOBLE CEDEX 09 (FR)
(74) Mandataire: Cabinet Beaumont

(57) **Abrégé**

La présente description concerne un procédé de préparation d'un substrat d'intérêt structuré (100) comprenant les étapes suivantes :
- fournir un substrat d'intérêt (100) comprenant une couche mince (120), sur laquelle une couche de protection (220) a été collée par collage direct,
- déposer une résine (300), et graver la couche mince (120) et une partie du substrat support (110) à travers des ouvertures de la résine, pour former des plots,
- coller un substrat temporaire (200) sur le substrat d'intérêt (100), puis les séparer, moyennant quoi la couche de protection (220) est séparée du substrat d'intérêt (100),

la résine (300) étant retirée avant l'étape de collage ou pendant la séparation,
l'énergie d'adhérence couche de protection (220) / couche mince (120) étant inférieure à l'énergie d'adhérence substrat temporaire (400) / couche de protection (220) ou à l'énergie d'adhérence résine (300) / couche de protection (220).

## Description

### Domaine technique

La présente description concerne de façon générale le domaine de la microélectronique, et plus particulièrement, un procédé de préparation d'un substrat structuré pouvant être utilisé pour un collage direct.

### Technique antérieure

Dans le domaine de la microélectronique, le collage de substrats structurés est particulièrement intéressant. Par exemple, il peut s'agir de coller une surface hybride Cu/SiO₂ sur une autre surface hybride Cu/SiO₂ structurée présentant des plots (ou marches). La structuration est généralement réalisée par des étapes de photolithographie/gravure.

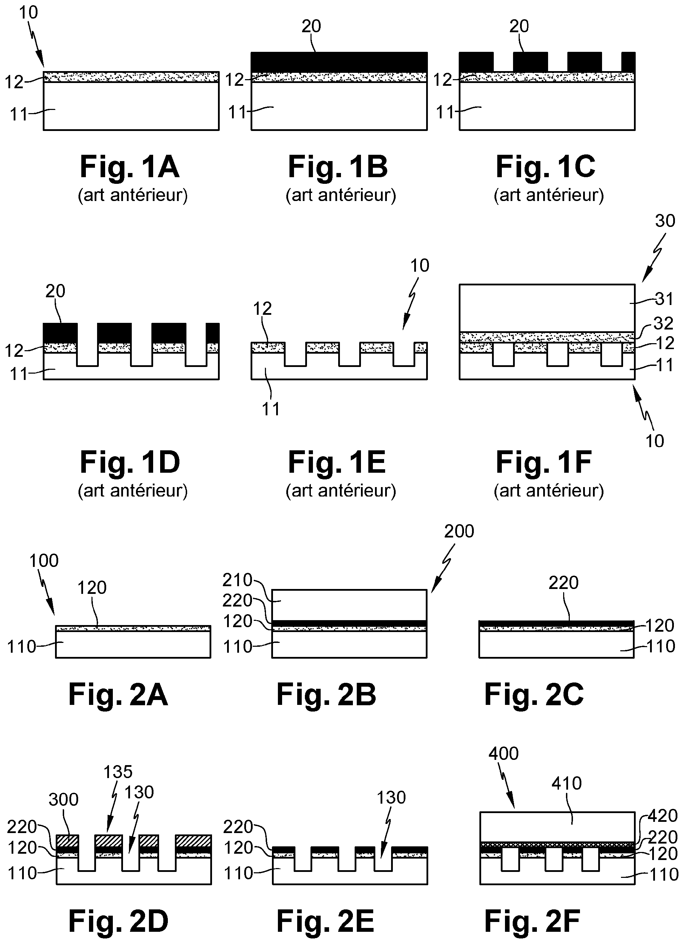

Plus particulièrement, comme représenté sur les figures 1A à 1E, un tel substrat structuré peut être réalisé selon le procédé suivant :
- fournir un substrat 10, ayant été préalablement poli, comprenant un substrat support 11 recouvert par une couche hybride 12 Cu/SiO₂ (figure 1A),
- déposer une couche de résine 20 sur le substrat 10 (figure 1B),
- former des ouvertures dans la couche de résine 20 (figure 1C),
- graver la couche hybride 12 et une partie du substrat support 11 à travers les ouvertures, moyennant quoi on obtient un substrat structuré 10 (figure 1D),
- retirer la résine 20 (figure 1E).

Le substrat structuré 10 peut ensuite être collé avec un autre substrat 30 comprenant un substrat support 31 et une couche hybride 32 Cu/SiO₂ (figure 1F).

Les procédés d'assemblage par collage direct nécessitent une minutieuse préparation des surfaces des substrats qui vont être assemblées. Leur état de surface est primordial pour la réussite du collage et les contaminations chimique et particulaire doivent être évitées.

Il est donc important de pouvoir retirer complètement la résine.

Des procédés de nettoyages par plasma associés à des nettoyages par voie humide peuvent être mis en œuvre pour retirer l'ensemble des contaminations.

Cependant, ces procédés de nettoyage sont relativement agressifs, ce qui peut dégrader la qualité de la surface à coller (notamment sa rugosité). Ceci est particulièrement vrai pour des surfaces comprenant du cuivre, typiquement des surfaces hybrides Cu/SiO₂.

Le nettoyage de la résine peut donc détériorer la surface hybride qui a été préalablement polie par polissage mécano-chimique.

Le collage des deux substrats est alors de mauvaise qualité.

De plus, il est impossible de polir à nouveau la surface car la structuration fait que le procédé de polissage arrondirait les bords des plots et empêcherait le collage dans ces zones.

### Résumé de l'invention

Il existe un besoin d'avoir un procédé de préparation d'un substrat d'intérêt structuré pouvant être utilisé ultérieurement pour un collage direct, le procédé devant permettre d'obtenir des surfaces des substrats de bonne qualité. Ce besoin est particulièrement important pour des substrats ayant des surfaces hybrides Cu/SiO₂.

Ce but est atteint par un procédé de préparation d'un substrat d'intérêt structuré pour collage direct comprenant les étapes suivantes :
a) fournir un substrat d'intérêt comprenant un substrat support et une couche mince,
b) coller une couche de protection sur la couche mince par collage direct,
c) déposer une résine sur la couche de protection, et former des ouvertures dans la résine,
d) graver la couche de protection, la couche mince et une partie de l'épaisseur du substrat support à travers les ouvertures de la résine, de manière à former des plots dans le substrat d'intérêt,
e) coller un substrat temporaire et le substrat d'intérêt,
f) séparer le substrat temporaire du substrat d'intérêt, moyennant quoi la couche de protection est séparée du substrat d'intérêt et on obtient un substrat d'intérêt structuré pour collage direct,

procédé dans lequel soit la résine est retirée entre l'étape d) et l'étape e) et l'énergie d'adhérence entre la couche de protection et la couche mince est inférieure à l'énergie d'adhérence entre le substrat temporaire et la couche de protection,
soit la résine est retirée lors de l'étape f) et l'énergie d'adhérence entre la couche de protection et la couche mince est inférieure à l'énergie d'adhérence entre la résine et la couche de protection.

Selon un mode de réalisation particulier, l'étape b) est réalisée en collant sur le substrat d'intérêt un substrat de transfert comprenant un substrat support et la couche de protection, puis en retirant le substrat support.

Selon un mode de réalisation particulier, la couche mince est une couche hybride Cu/SiO₂ comprenant une couche mince en oxyde de silicium dans laquelle sont formés des plots en cuivre.

Selon un mode de réalisation particulier, la couche de protection est en SiO₂.

Selon un mode de réalisation particulier, l'énergie d'adhérence entre la couche de protection et la couche mince est inférieure d'au moins 0,5 J/m² à l'énergie d'adhérence entre le substrat temporaire et la couche de protection, ou l'énergie d'adhérence entre la couche de protection et la couche mince est inférieure d'au moins 0,5 J/m² à l'énergie d'adhérence entre la résine et la couche de protection.

Selon un mode de réalisation particulier, les étapes du procédé sont réalisées à une température inférieure ou égale à 150°C.

Selon un mode de réalisation particulier, le procédé comprend une étape de singularisation au cours de laquelle le substrat d'intérêt est séparé en plusieurs parties, au niveau de chemins de découpe positionnés entre les plots, afin de former des puces d'intérêt, l'étape de singularisation étant, de préférence, réalisée au moyen d'une étape d'irradiation laser, d'une étape de gravure plasma ou d'une étape de découpe à la scie.

Selon un mode de réalisation particulier, l'étape d'irradiation laser est réalisée, entre l'étape d) et l'étape e) ou entre l'étape e) et l'étape f), l'irradiation laser conduisant à la formation de zones fragilisées au niveau des chemins de découpe, et le substrat d'intérêt est collé sur un film adhésif étirable, le film adhésif étirable étant étiré, après l'étape d'irradiation laser, de manière à séparer les puces d'intérêt au niveau des zones fragilisées.

Selon un mode de réalisation particulier, l'étape de gravure plasma est réalisée, entre l'étape d) et l'étape e), le substrat d'intérêt étant collé sur un film adhésif lors de l'étape de gravure plasma et lors des étapes e) et f).

Selon un mode de réalisation particulier, l'étape de gravure plasma est réalisée entre l'étape e) et l'étape f), le substrat d'intérêt étant collé sur un film adhésif lors de l'étape f).

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D, la figure 1E et la figure 1F, précédemment décrites, représentent de manière schématique différentes étapes d'un procédé de fabrication d'un substrat d'intérêt selon l'art antérieur ;
la figure 2A, la figure 2B, la figure 2C, la figure 2D, la figure 2E, la figure 2F et la figure 2G représentent de manière schématique différentes étapes d'un procédé de fabrication d'un substrat d'intérêt selon un mode de réalisation particulier ;
la figure 3A, la figure 3B, la figure 3C, la figure 3D, la figure 3E et la figure 3F représentent de manière schématique différentes étapes d'un procédé de fabrication d'un substrat d'intérêt selon un autre mode de réalisation particulier ;
la figure 4A, la figure 4B, la figure 4C, la figure 4D, la figure 4E, la figure 4F, la figure 4G, la figure 4H et la figure 4I représentent de manière schématique différentes étapes d'un procédé de fabrication d'un substrat d'intérêt selon un autre mode de réalisation particulier ;
la figure 5A, la figure 5B, la figure 5C, la figure 5D, la figure 5E, la figure 5F, la figure 5G et la figure 5H représentent de manière schématique différentes étapes d'un procédé de fabrication d'un substrat d'intérêt selon un autre mode de réalisation particulier ; et
la figure 6A, la figure 6B, la figure 6C, la figure 6D, la figure 6E, la figure 6F, la figure 6G, la figure 6H et la figure 6I représentent de manière schématique différentes étapes d'un procédé de fabrication d'un substrat d'intérêt selon un autre mode de réalisation particulier.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Même si la description fait particulièrement référence à des substrats structurés ayant une surface à coller hybride Cu/SiO₂, le procédé peut être appliqué à d'autres substrats structurés.

Toutes les énergies d'adhérence données sont déterminées par la méthode du double levier à déplacement imposé (comme expliqué dans l'article de Fournel et al. 'Measurement of bonding energy in an anhydrous nitrogen atmosphere and its application to silicon direct bonding technology', Journal of Applied Physics 111, 104907 (2012)).

Nous allons maintenant décrire plus en détail le procédé de préparation d'un substrat d'intérêt structuré 100 ou de puces d'intérêt 150 en faisant référence aux figures 2A à 2G, 3A à 3F, 4A à 4I, 5A à 5H et 6A à 6I.

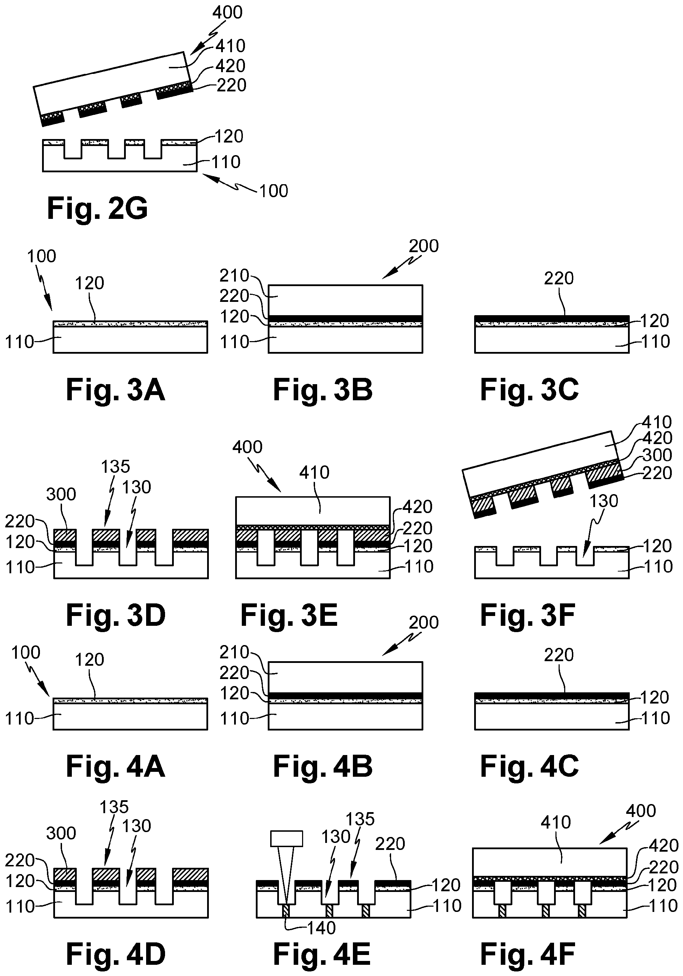

Le procédé comprend au moins les étapes suivantes :
a) fournir un substrat d'intérêt 100 comprenant un substrat support 110 et une couche mince 120 (figures 2A, 3A, 4A, 5A, 6A),
b) recouvrir la couche mince 120 par une couche de protection 220 (figures 2C, 3C, 4C, 5C, 6C),
c) déposer une résine 300 sur la couche de protection 220, et former des ouvertures dans la résine 300,
d) graver la couche de protection 220, la couche mince 120 et une partie de l'épaisseur du substrat support 110 à travers les ouvertures de la résine, de manière à former des plots 135 dans le substrat d'intérêt 100 (figures 2D, 3D, 4D, 5D, 6D),
e) coller un substrat temporaire 400 sur le substrat d'intérêt 100 (figures 2F, 3E, 4F, 5F, 6F),
f) séparer le substrat temporaire 400 du substrat d'intérêt 100 (figures 2G, 3F, 4G, 5G, 6I).

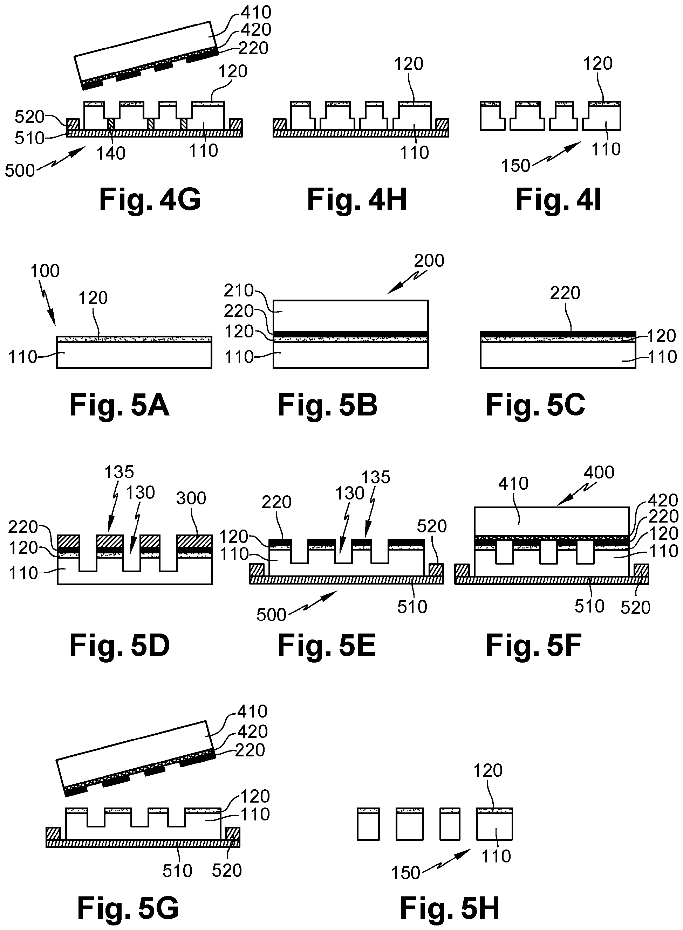

Le procédé peut comprendre en outre une étape additionnelle au cours de laquelle le substrat d'intérêt 100 est séparé en plusieurs parties pour former des puces d'intérêt 150 (figures 4H, 5F, 6H). Cette étape additionnelle peut être réalisée entre l'étape c) et l'étape d), entre l'étape d) et l'étape e), ou après l'étape e).

La couche de protection 220 (aussi appelée couche d'arrêt de gravure) présente une adhérence Eadh0 relativement faible (typiquement inférieure à 1 J/m²). Elle est facilement séparée du substrat d'intérêt 100 lors de l'étape f) : elle est retirée en même temps que le substrat temporaire 400. A l'issue de l'étape f, on obtient un substrat d'intérêt 100 structuré pouvant être utilisé pour collage direct.

Pour garantir une faible adhérence Eadh0, les températures de procédé mises en œuvre lors du procédé seront de préférence inférieures à 150°C et/ou le collage est un collage direct à faible adhérence, comme un collage mettant en jeu une surface de silicium hydrophobe.

Dans ce procédé, la couche de protection 220 est maintenue sur la couche mince 120 du substrat d'intérêt 100 au moyen d'un procédé de collage direct. Il n'y a pas besoin d'utiliser de colle ou de polymère. La surface de la couche mince 120 est ainsi préservée.

Le procédé comprend en outre une étape au cours de laquelle la résine 300 est retirée.

Selon un premier mode de réalisation, représenté par exemple sur les figures 2A à 2G, 4A à 4I, 5A à 5H et 6A à 6I, la résine 300 est retirée entre l'étape d) et l'étape e) afin de rendre accessible la couche de protection 220. Lors de l'étape e), le substrat temporaire 400 est collé sur la surface nettoyée de la couche de protection 220.

La résine 300 peut être retirée au moyen d'étapes d'oxydation plasma et de nettoyage par voie humide. La couche de protection 220 protège la couche mince 120 lors de cette étape.

Le substrat temporaire 400 peut être formé d'un substrat massif ou il peut s'agir d'un substrat massif 410 recouvert par une couche adhésive 420. L'utilisation d'une couche adhésive 420 permet d'être très tolérant en ce qui concerne la qualité de la surface de la couche d'arrêt. L'adhérence de collage entre le substrat temporaire 400 et la couche de protection 220 Eadh1 est forte (typiquement supérieure à 1,5 J/m²). L'énergie Eadh1 est supérieure à l'énergie Eadh0. Ainsi, lors de l'étape f), le décollement du substrat temporaire 400 va conduire à l'ouverture de l'interface d'adhérence la plus faible : il s'agit de l'interface entre la couche de protection 220 et la couche mince 120 du substrat d'intérêt 100. La surface du substrat d'intérêt 100 se retrouve libérée et est compatible avec un procédé de collage direct.

Selon un deuxième mode de réalisation, représenté par exemple sur les figures 3A à 3F, la résine 300 est retirée lors de l'étape f).

Comme pour le premier mode de réalisation, le substrat temporaire 400 peut être un substrat massif ou comprendre un substrat massif 410 recouvert par une couche adhésive 420, ce qui rend le collage très tolérant à l'état de surface de la résine 300. L'adhérence Eadh2 entre la résine 300 et la couche de protection 120 est forte (typiquement supérieure à 1,5 J/m²). Elle est supérieure à Eadh0. Le décollement de ce substrat 400 va conduire au détachement de l'interface entre la couche de protection 220 et la surface du substrat d'intérêt 100. La surface du substrat d'intérêt 100 se retrouve libérée et est compatible avec un procédé de collage direct. La couche de protection 220 et la résine sont retirées en même temps que le substrat temporaire 400.

Le substrat d'intérêt 100 fourni à l'étape a) est, de préférence, une plaque.

Le substrat d'intérêt 100 comprend une face avant et une face arrière. La face avant correspond à la face que l'on souhaite préparer pour le collage direct.

Le substrat d'intérêt 100 comprend un substrat support 110 et une couche mince 120. Le substrat support 110 est, par exemple, un substrat en matériau semiconducteur (de préférence, Si, Ge, SiC, AsGa), en saphir ou en silice.

Le substrat d'intérêt 100 fourni à l'étape a) peut être un substrat SOI ('Silicon on Insulator'), c'est-à-dire comprenant un substrat support recouvert successivement par une fine couche d'oxyde enterré et une couche de silicium.

Il peut également s'agir d'un substrat massif 110 en matériau semiconducteur recouvert d'une couche 120 diélectrique, en particulier une couche d'oxyde (oxyde de silicium notamment).

La couche mince 120 est, par exemple, une couche métallique, une couche d'oxyde (notamment, une couche d'oxyde de silicium), une couche d'un matériau III/V ou IV/VI, une couche de germanium, de SiC, de silicium ou de saphir.

De préférence, la couche mince 120 est une couche hybride, formée d'au moins deux matériaux. De préférence, il s'agit d'une couche hybride Cu/SiO₂ comprenant une matrice en oxyde de silicium dans laquelle ont été formés des parties (plots) de cuivre. Les plots de cuivre ont par exemple de 2 µm de côté.

La face supérieure de la couche mince 120 correspond à la surface qui est structurée et préparée pour le collage direct.

Lors de l'étape b), la couche mince 120 du substrat d'intérêt 100 est recouverte par une couche de protection 220.

La couche de protection 220 peut être une couche d'oxyde de silicium, une couche de silicium (aussi appelée couche de silicium hydrophobe, i.e. une couche dont le silicium présente des terminaisons Si-H), une couche de nitrure (comme du nitrure d'aluminium), ou une couche de polymère. Il peut s'agir aussi d'une couche composée de plusieurs matériaux avec, par exemple, du silicium recouvert d'une couche d'oxyde de silicium.

Selon un mode de réalisation préféré, la couche de protection 220 est collée par collage direct sur le substrat d'intérêt 100. Ceci permet d'avoir un contact intime entre la couche de protection 220 et la couche mince 120 du substrat d'intérêt 100.

Ce mode de réalisation peut être réalisé selon les étapes suivantes :
i) coller sur le substrat d'intérêt 100 un substrat de transfert 200 comprenant un support 210 et la couche de protection 220 (figures 2B, 3B, 4B, 5B, 6B),
ii) retirer le support 210 du substrat de transfert 200, de manière à former un ensemble comprenant le substrat d'intérêt 100 recouvert par la couche de protection 220 (figures 2C, 3C, 4C, 5C, 6C).

Lors de l'étape i), le substrat temporaire 200 et le substrat d'intérêt 100 sont assemblés par collage direct. Le collage direct peut être réalisé à la pression atmosphérique (soit 1013,25 hPa) ou sous vide (de l'ordre de l'hPa).

Préalablement à l'étape i), le substrat de transfert 200 sera, avantageusement, détouré. Le détourage du bord de plaque 200 permet d'éviter d'éventuels problèmes de bord, notamment si l'étape ii) est réalisée par amincissement.

Le détourage peut être réalisé, par exemple, par photolithographie/gravure ou encore par détourage mécanique au moyen d'une scie diamantée. La largeur du détourage est comprise, par exemple, entre 1 et 5 mm et/ou sa profondeur comprise, par exemple, entre 100 et 250 µm.

L'étape ii) peut être réalisée par amincissement.

L'étape ii) peut être réalisée au moyen d'une technique de décollement par laser ('laser lift-off'). Par exemple, le support 210 peut être formé d'un substrat transparent recouvert d'une couche de démontage.

Un support 210 en silicium peut être utilisé avec la technologie Nanocleave de la société EVGroup pour le décollement par laser.

Le substrat support 210 du substrat temporaire 200 peut être utilisé dans un nouveau cycle de collage/gravure. Un nettoyage est, avantageusement, réalisé entre chaque utilisation.

Par exemple, il est possible de le recycler en mettant en œuvre un traitement plasma oxygène suivi d'un nettoyage par voie humide.

A chaque utilisation, une nouvelle couche de protection peut être, si besoin, formée sur le substrat support 210 avant d'être réutilisé.

Lors de l'étape c), une résine 300 est déposée sur la couche de protection 220. Des ouvertures sont formées dans la résine au droit des cavités 130 du substrat d'intérêt 100 que l'on souhaite former. La résine 300 joue le rôle de masque.

Lors de l'étape d), la couche de protection 220, la couche mince 120 et une partie de l'épaisseur du substrat support 110 est gravée.

Des plots 135 sont ainsi formés dans le substrat d'intérêt 100. Les plots 135 sont séparés par des espaces 130.

Les plots 135 forment par exemple une marche carrée de 10 mm de côté et de 50 µm de profondeur.

Lors de l'étape e), un substrat temporaire 400 est collé avec le substrat d'intérêt 100.

Si la résine 300 a été retirée entre l'étape d) et l'étape e), le substrat temporaire 400 est collé sur la couche de protection 220.

Si la résine 300 n'a pas été retirée, le substrat temporaire 400 est collé sur la couche de résine 300.

Le substrat temporaire 400 comprend un substrat support 410 et une couche 420, de préférence une couche adhésive.

Lors de l'étape f), le substrat temporaire 400 est retiré. La couche de protection 220 et, le cas échéant, la résine 300 sont retirés simultanément. Cette étape est rendue possible grâce aux différences d'énergie d'adhérence mises en jeu.

Afin de favoriser le retrait de la couche de protection 120, il est possible d'effectuer une implantation d'espèce gazeuse avant le collage de l'étape e). L'implantation peut être réalisée à travers la couche de protection 120 et, potentiellement, à travers aussi la couche de résine 300.

Suite à cette étape d'implantation, un recuit thermique peut être mis en œuvre pour faire diffuser l'espèce gazeuse et favoriser le détachement à l'interface entre la couche d'intérêt 120 et la couche de protection 220.

A l'issue de l'étape f), des substrats d'intérêt structurés 100 sont obtenus (figures 2G et 3F). Leurs surfaces sont prêtes pour un collage direct.

Il est également possible de réaliser une étape additionnelle au cours de laquelle le substrat d'intérêt 100 est découpé ou gravé, au niveau des espaces 130 entre les plots 135, pour obtenir des puces d'intérêt 150 dont la surface est prête pour un collage direct (comme représenté sur les figures 4I, 5H et 6I).

La découpe ou gravure est réalisée sur toute l'épaisseur du substrat 110.

Cette étape peut être réalisée avant l'étape e) ou après l'étape f).

Elle peut être réalisée au moyen de différentes techniques.

Selon une première variante de réalisation, représentée sur les figures 4E à 4I, la découpe est réalisée au moyen d'un laser (découpe par 'Stealth Dicing').

Dans un premier temps, une irradiation laser est réalisée entre les plots 135 pour former des zones fragilisées 140. Cette étape peut être réalisée, avant l'étape e), soit en irradiant à partir de la face avant du substrat d'intérêt 100 soit en irradiant à partir de la face arrière. Alternativement, cette étape d'irradiation laser peut être réalisée après l'étape e), en irradiant la face arrière du substrat d'intérêt. Pour une irradiation en face arrière (avant ou après collage des substrats), des marques d'alignement ou un alignement par vision infra-rouge pourront être mis en œuvre.

Après avoir réalisé l'étape d'irradiation (figure 4E) et l'étape de collage (figure 4F) du substrat d'intérêt 100 avec le substrat temporaire 400 (ou inversement), le substrat d'intérêt 100 est collé sur un dispositif 500 comprenant un film adhésif 510 maintenu par un pourtour ('frame') métallique 520. Le substrat temporaire 400 est ensuite décollé afin de retirer la couche de protection 220 de la face avant du substrat d'intérêt (figure 4G). Puis, le film adhésif étirable 510 est étiré (figure 4H) pour provoquer la fracture du substrat d'intérêt 100 au niveau des zones fragilisées 140 par l'irradiation. On obtient ainsi les puces d'intérêt 150. Les puces 150 sont ensuite retirées du film étirable 510.

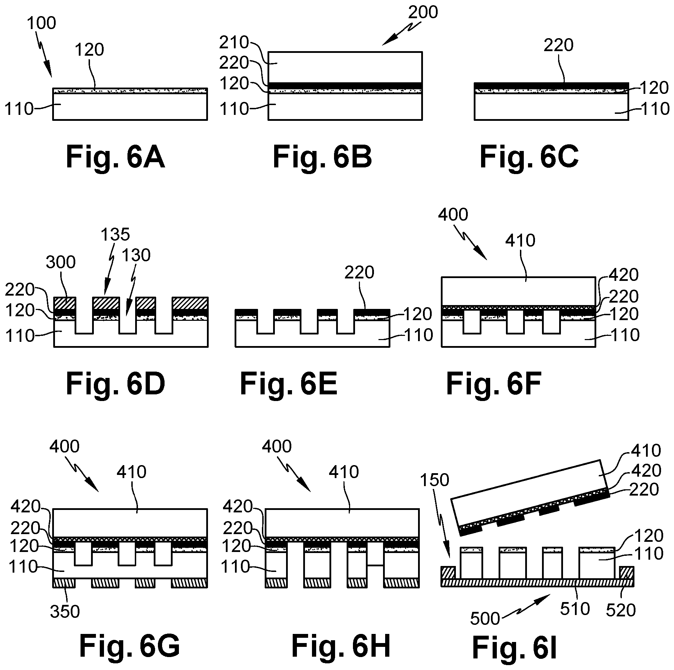

Selon une deuxième variante de réalisation, comme représenté sur les figures 5E à 5H et 6G à 6I, la découpe du substrat 100 est réalisée au moyen d'un plasma. Il s'agit d'une découpe dite profonde.

Par exemple, la découpe profonde du substrat 100, notamment en silicium, peut être réalisée avec un procédé Bosch.

Selon une première variante de réalisation, comme représentées sur les figures 5E et 5F, la gravure peut être réalisée à partir de la face avant du substrat d'intérêt 100 juste avant l'étape e).

Afin de singulariser les puces 150, le substrat d'intérêt 100 est collé sur un dispositif 500 comprenant un film adhésif 510 maintenu par un pourtour ('frame') métallique 520 (figure 5E). Puis l'étape de gravure est réalisée. La couche de protection 220 peut jouer le rôle de masque dur pendant la gravure, ce qui permet de diminuer la durée du procédé.

Le substrat temporaire 400 est ensuite collé (figure 5F). Lors du décollement du substrat temporaire 400, on obtient des puces d'intérêt 150 fixées sur le film adhésif 510 (figure 5G). Après séparation du film adhésif 510, les puces sont prêtes à être utilisées (figure 5H).

Selon une deuxième variante de réalisation, comme représentées sur les figures 6F à 6I, la gravure profonde du substrat d'intérêt 100 peut être réalisée après l'étape e), à partir de la face arrière du substrat d'intérêt 100. Un masque dur sera préalablement déposé en face arrière du substrat d'intérêt 100 (figure 6G), avant ou après collage avec le substrat temporaire 400.

A la fin de l'étape de gravure, les puces 150 sont maintenues grâce au collage avec le substrat temporaire 400 (figure 6H). Il n'y a pas besoin d'utiliser d'adhésif lors de cette étape, ce qui nécessite des équipements moins complexes et simplifie le procédé.

Une fois la gravure réalisée, le masque dur est retiré. Puis, la face arrière du substrat d'intérêt 100 est fixée sur un dispositif 500 comprenant un film adhésif 510 maintenu par un pourtour ('frame') métallique 520, puis le substrat temporaire 400 est décollé pour obtenir les puces d'intérêt (figure 6I).

Il est possible de mixer les deux dernières variantes en faisant une première gravure profonde en face avant du substrat support 110 en utilisant astucieusement la couche 220 comme masque dur. Comme c'est une gravure partielle, il n'y a pas besoin du film adhésif 510. Ensuite, on colle sur le substrat temporaire 400 et on peut faire un amincissement de la face arrière du substrat support 110 par la même technique de gravure profonde en ayant mis un masque dur ou on peut faire une gravure sur l'ensemble de la surface. Cette dernière option revient à amincir les puces jusqu'à déboucher dans la première gravure profonde partielle. Ensuite, on colle le substrat support 110 au film adhésif 510 et on décolle le substrat temporaire 400.

Selon une troisième variante de réalisation, non représentée, la découpe est réalisée mécaniquement, notamment au moyen d'une scie.

Le substrat d'intérêt 100 peut être découpé avant ou après le collage avec le substrat temporaire 400.

Lorsque le substrat 100 est découpé avant collage avec le substrat temporaire 400, il est préalablement fixé à un dispositif 500 comprenant un film adhésif maintenu par un pourtour, puis scié pour obtenir les puces d'intérêts 150. Les puces 150 sont ensuite collées au substrat temporaire, puis ce dernier est décollé afin de retirer la couche de protection 220 et obtenir les puces d'intérêt 150.

Lorsque le substrat 100 est découpé après collage avec le substrat temporaire 400, on veillera à ne pas découper le substrat temporaire 400 ou une très faible épaisseur du substrat temporaire 400 pour ne pas le fragiliser et garder un décollement fonctionnel. Cette variante de réalisation est particulièrement avantageuse car, non seulement, elle permet de réaliser une découpe sans utiliser de film adhésif mais, aussi, la future face avant des puces d'intérêt 150 ne sera absolument pas perturbée par la possible contamination particulaire de la découpe car le collage de protection est en place. Après la découpe, la face arrière du substrat d'intérêt 100 est positionnée sur un film adhésif maintenu par un pourtour et le substrat temporaire 400 est décollé. Les puces d'intérêt 150 sont obtenues.

Il est également possible de découper le substrat en mettant en œuvre un clivage. Le clivage peut être amorcé en réalisant une entaille dans le substrat, par exemple, au moyen d'une pointe diamantée.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

### Exemples illustratifs et non limitatifs de différents modes de réalisation

### Exemple 1 :

Sur une plaque d'intérêt de silicium, on réalise par un procédé Damascène des plots de cuivre de 2 µm de côté dans une matrice SiO₂. Cette plaque subit un procédé de polissage mécano-chimique de façon à la rendre compatible avec un procédé de collage direct. Un substrat de transfert de type SOI est utilisé. Il comprend un film de silicium de 205 nm sur une couche d'oxyde de 400 nm. Il est détouré par une scie diamantée sur une profondeur de 250 µm et une largeur de 1,5 mm. On réalise un nettoyage de la surface du substrat de transfert de façon à la rendre compatible avec un procédé de collage direct hydrophile.

On assemble le substrat d'intérêt et le substrat de transfert par collage direct.

On vient amincir le substrat de transfert à 50µm puis on retire le silicium restant par une gravure plasma à base de SF₆. La gravure s'arrête sur la couche d'oxyde de 400nm. On peut aussi graver le silicium au moyen d'une solution aqueuse de HF/HNO₃. On retire enfin la couche de SiO₂ par une gravure humide à base de HF.

On réalise une étape de photolithographie/gravure sur cette structure de façon à obtenir des plots de 50 µm d'épaisseur et de 10 mm de côté.

On colle cette structure sur un substrat temporaire 400 recouvert par un film adhésif. Par exemple, il s'agit d'un film adhésif commercialisé par Furukawa sous la référence SP5207M-425. Il comprend une couche adhésive de 5µm.

La face arrière du substrat d'intérêt est placé sur une table aspirante. En insérant un coin dans le collage, on démonte l'ensemble. L'ouverture sépare l'interface entre le substrat d'intérêt et le film de silicium du substrat temporaire. On obtient une surface de plots de cuivre de 2 µm de coté sur une marche carrée de 10 mm de côté et de 50 µm de profondeur directement compatible avec un procédé de collage direct.

### Exemple 2 :

Sur une plaque d'intérêt de silicium, on réalise par un procédé Damascène des plots de cuivre de 2 µm de côté dans une matrice SiO₂. Cette plaque subit un procédé de polissage mécano-chimique de façon à la rendre compatible avec un procédé de collage direct. Un substrat de transfert de type SOI comprend un film de silicium de 205 nm sur une couche d'oxyde de 400nm. Ce substrat est détouré par une scie diamantée sur une profondeur de 250µm et une largeur de 1,5 mm. On réalise un nettoyage de la surface du substrat de transfert au moyen d'un traitement désoxydant à base de HF de façon à préparer un collage direct hydrophobe.

On assemble le substrat d'intérêt et le substrat de transfert par collage direct.

On vient amincir le substrat de transfert à 50µm puis on retire le silicium restant par une gravure plasma à base de SF₆ qui s'arrête sur la couche d'oxyde de 400nm. On peut aussi graver le silicium au moyen d'une solution aqueuse de HF/HNO₃. On retire enfin la couche de SiO₂ par une gravure humide à base de HF.

On réalise une étape de photolithographie/gravure sur cette structure de façon à obtenir des plots de 50 µm d'épaisseur de 10 mm de côté.

On colle cette structure sur un substrat temporaire comprenant un adhésif tel qu'un film adhésif commercialisé par la société Furukawa sous la référence SP5207M-425. Le film adhésif a une épaisseur de 5µm. La face arrière du substrat d'intérêt est ensuite placé sur une table aspirante. En insérant un coin dans le collage, on démonte l'ensemble. L'ouverture sépare l'interface entre le substrat d'intérêt et le film de silicium. On obtient une surface de plots de cuivre de 2 µm de coté sur une marche carrée de 10 mm de côté et de 50 µm de profondeur directement compatible avec un procédé de collage direct.

### Exemple 3 :

Sur une plaque d'intérêt de silicium, on réalise, par un procédé Damascène, des plots de cuivre de 2 µm de côté dans une matrice SiO₂. Cette plaque subit un procédé de polissage mécano-chimique de façon à la rendre compatible avec un procédé de collage direct. Sur un substrat temporaire en silicium, on dépose par dépôt chimique en phase vapeur 1 µm de SiO₂. Cette plaque est ensuite détourée par une scie diamantée sur une profondeur de 250µm et une largeur de 1,5 mm. On réalise un nettoyage de la surface du substrat de transfert puis un polissage mécano-chimique.

On assemble le substrat d'intérêt et le substrat de transfert par collage direct. On vient amincir S1t à 50µm puis on retire le silicium restant par une gravure plasma SF₆ qui s'arrête sur la couche d'oxyde de 1 µm.

On réalise une étape de photolithographie/gravure sur cette structure de façon à obtenir des plots de 50 µm d'épaisseur de 10 mm de côté.

On colle cette structure sur un substrat temporaire comprenant une plaque de verre sur laquelle on a étalé 10 µm d'adhésif commercialisé sous la référence LC5200. Le collage est réalisé à température ambiante par insolation UV. La face arrière du substrat d'intérêt est ensuite placé sur une table aspirante. En insérant un coin dans le collage, on démonte l'ensemble. L'ouverture sépare l'interface entre le substrat d'intérêt et le film d'oxyde du substrat de transfert. On obtient une surface de plots de cuivre de 2 µm de coté sur une marche carrée de 10 mm de côté et de 50 µm de profondeur directement compatible avec un procédé de collage direct.

### Exemple 4 :

Sur une plaque d'intérêt de silicium, on réalise, par un procédé Damascène, des plots de cuivre de 2 µm de côté dans une matrice SiO₂. Cette plaque subit un procédé de polissage mécano-chimique de façon à la rendre compatible avec un procédé de collage direct. Sur un substrat de transfert en silicium, on dépose par dépôt chimique en phase vapeur 1 µm de SiO₂. Cette plaque est ensuite détourée par une scie diamantée sur une profondeur de 250µm et une largeur de 1,5 mm. On réalise un nettoyage de la surface du substrat de transfert puis un polissage mécano-chimique.

On assemble le substrat d'intérêt et le substrat temporaire par collage direct. On vient amincir le substrat de transfert à 50µm puis on retire le silicium restant par une gravure plasma SF₆ qui s'arrête sur la couche d'oxyde de 1 µm.

Au moyen d'une résine commercialisée sous la référence TOK TDMR d'une épaisseur de 1µm, on réalise une étape de photolithographie/gravure sur la structure de façon à obtenir des plots de 50 µm d'épaisseur de 10 mm de côté. Après gravure, la résine n'est pas retirée au moyen des techniques classiques de gravures par plasma combiné avec un nettoyage humide.

On colle cette structure sur un substrat temporaire comprenant une plaque de verre sur laquelle on a étalé 10 µm d'adhésif commercialisé sous la référence LC5200. Le collage est réalisé à température ambiante par insolation UV. La structure est placée sur une table aspirante : la face arrière du substrat d'intérêt est aspirée. En insérant un coin dans le collage, on démonte l'ensemble. L'ouverture sépare l'interface entre le substrat d'intérêt et le film d'oxyde provenant du substrat de transfert. On obtient une surface de plots de cuivre de 2 µm de coté sur une marche carrée de 10 mm de côté et de 50 µm de profondeur directement compatible avec un procédé de collage direct.

## Revendications

1. Procédé de préparation d'un substrat d'intérêt structuré (100) pour collage direct comprenant les étapes suivantes :
a) fournir un substrat d'intérêt (100) comprenant un substrat support (110) et une couche mince (120),
b) coller une couche de protection (220) sur la couche mince (120) par collage direct,
c) déposer une résine (300) sur la couche de protection (220), et former des ouvertures dans la résine (300),
d) graver la couche de protection (220), la couche mince (120) et une partie de l'épaisseur du substrat support (110) à travers les ouvertures de la résine, de manière à former des plots (135) dans le substrat d'intérêt (100),
e) coller un substrat temporaire (400) et le substrat d'intérêt (100),
f) séparer le substrat temporaire (400) du substrat d'intérêt (100), moyennant quoi la couche de protection (220) est séparée du substrat d'intérêt (100) et on obtient un substrat d'intérêt (100) structuré pour collage direct, procédé dans lequel soit la résine (300) est retirée entre l'étape d) et l'étape e) et l'énergie d'adhérence entre la couche de protection (220) et la couche mince (120) est inférieure à l'énergie d'adhérence entre le substrat temporaire (400) et la couche de protection (220),
soit la résine (300) est retirée lors de l'étape f) et l'énergie d'adhérence entre la couche de protection (220) et la couche mince (120) est inférieure à l'énergie d'adhérence entre la résine (300) et la couche de protection (220).

2. Procédé selon la revendication 1, **caractérisé en ce que** l'étape b) est réalisée en collant sur le substrat d'intérêt (100) un substrat de transfert (200) comprenant un substrat support (210) et la couche de protection (220), puis en retirant le substrat support (210).

3. Procédé selon l'une des revendications 1 et 2, **caractérisé en ce que** la couche mince (120) est une couche hybride Cu/SiO₂ comprenant une couche mince en oxyde de silicium dans laquelle sont formés des plots en cuivre.

4. Procédé selon l'une quelconque des revendications précédentes, **caractérisé en ce que** la couche de protection (220) est en SiO₂.

5. Procédé selon l'une quelconque des revendications précédentes, **caractérisé en ce que** l'énergie d'adhérence entre la couche de protection (220) et la couche mince (120) est inférieure d'au moins 0,5 J/m² à l'énergie d'adhérence entre le substrat temporaire (400) et la couche de protection (220),
ou **en ce que** l'énergie d'adhérence entre la couche de protection (220) et la couche mince (120) est inférieure d'au moins 0,5 J/m² à l'énergie d'adhérence entre la résine (300) et la couche de protection (220).

6. Procédé selon l'une quelconque des revendications précédentes, **caractérisé en ce que** les étapes du procédé sont réalisées à une température inférieure ou égale à 150°C.

7. Procédé selon l'une quelconque des revendications précédentes, **caractérisé en ce que** le procédé comprend une étape de singularisation au cours de laquelle le substrat d'intérêt (100) est séparé en plusieurs parties, au niveau de chemin de découpe positionnés entre les plots (135), afin de former des puces d'intérêt (150), l'étape de singularisation étant, de préférence, réalisée au moyen d'une étape d'irradiation laser, d'une étape de gravure plasma ou d'une étape de découpe à la scie.

8. Procédé selon la revendication 7, **caractérisé en ce que** l'étape d'irradiation laser est réalisée, entre l'étape d) et l'étape e) ou entre l'étape e) et l'étape f), l'irradiation laser conduisant à la formation de zones fragilisées (140) au niveau des chemins de découpe, et **en ce que** le substrat d'intérêt (100) est collé sur un film adhésif étirable (510), le film adhésif étirable (510) étant étiré, après l'étape d'irradiation laser, de manière à séparer les puces d'intérêt (150) au niveau des zones fragilisées (140).

9. Procédé selon la revendication 7, **caractérisé en ce que** l'étape de gravure plasma est réalisée, entre l'étape d) et l'étape e), le substrat d'intérêt (100) étant collé sur un film adhésif (510) lors de l'étape de gravure plasma et lors des étapes e) et f).

10. Procédé selon la revendication 7, **caractérisé en ce que** l'étape de gravure plasma est réalisée entre l'étape e) et l'étape f), le substrat d'intérêt (100) étant collé sur un film adhésif (510) lors de l'étape f).
